# EUROPÄISCHE PATENTANMELDUNG

(11) **EP 3 627 969 A2**
(43) Veröffentlichungstag der Anmeldung: **25.03.2020**
(21) Anmeldenummer: 19197691.9
(22) Anmeldetag: 17.09.2019
(51) Int. Cl.: H05B 6/78

(54) **VERFAHREN ZUM AUFBRINGEN VON LEITERMATERIAL AUF SUBSTRATEN**

(30) Priorität: 21.09.2018 DE 102018123261
(71) Anmelder: Fraunhofer-Gesellschaft zur Förderung der angewandten Forschung e.V., 80686 München (DE)
(72) Erfinder: Dreyer, Christian, 55758 Niederwörresbach (DE); Hartmann, Lutz, 14513 Teltow (DE); Ischdonat, Nils, 20251 Hamburg (DE)
(74) Vertreter: Weisse, Renate

(57) **Zusammenfassung**

Ein Verfahren zum Aufbringen von Leitermaterial auf Substrate mit den Schritten: Aufbringen des Leitermaterials in einer flüssigen oder vorbehandelten Matrix auf ein Substrat; und Entfernen der Matrix und Sintern des Leitermaterials mittels Mikrowellenstrahlung, indem das aufgebrachte Leitermaterial mit der Matrix auf eine Temperatur oberhalb von 120°C gebracht wird, wobei die Materialeigenschaften des Leitermaterials und/oder des Substrats und/oder Behandlungsparameter derart ausgewählt sind, dass das Leitermaterial mehr erwärmt wird als das Substrat ist dadurch gekennzeichnet, dass das Substrat aus einem unpolaren und/oder mikrowellentransparenten, temperaturlabilen Material besteht, dessen Form, Zusammensetzung, Härte, mechanische Festigkeit, mechanische Steifigkeit oder anderer Zustand sich bei Erwärmung auf Temperaturen oberhalb von 120°C messbar ändert, so dass das Material für eine wirtschaftliche Verwertung ungeeignet ist, und das Substrat von einem Formteil mit drei-Dimensionalen Strukturen gebildet ist.

## Beschreibung

### Technisches Gebiet

Die Erfindung betrifft ein Verfahren zum Aufbringen von Leitermaterial auf Substrate mit den Schritten:
(a) Aufbringen des Leitermaterials in einer flüssigen oder vorbehandelten Matrix auf ein Substrat; und
(b) Entfernen der Matrix und Sintern des Leitermaterials mittels Mikrowellenstrahlung, indem das aufgebrachte Leitermaterial mit der Matrix auf eine Temperatur oberhalb von 120°C gebracht wird, wobei die Materialeigenschaften des Leitermaterials und/oder des Substrats und/oder Behandlungsparameter derart ausgewählt sind, dass das Leitermaterial mehr erwärmt wird als das Substrat.

Typischerweise erfolgt das Sintern von Leitermaterial in einem Ofen. Das Leitermaterial, die Matrix und das Substrat werden durch Wärmestrahlung vollständig erwärmt. Dabei werden nicht-erwünschte Bestandteile aus dem aufgebrachten Material ausgetrieben. Das Leitermaterial selber verbleibt als Feststoff auf dem Substrat.

Halbzeuge aus unterschiedlichen Materialien können durch den Auftrag leitfähiger Strukturen mittels verschiedener Druckverfahren wie InkJet- oder Aerosol-Druck funktionalisiert werden. Die Strukturen werden beispielsweise als Leiterbahnen zur Ansteuerung integrierter elektronischer Bauteile oder als Heizelemente verwendet. Für die mechanische Stabilisierung der gedruckten Strukturen und für das Erreichen einer hinreichenden elektrischen Leitfähigkeit ist ein Sinterprozess der gedruckten leitfähigen Tinten sinnvoll oder erforderlich. Der Sinterprozess erfolgt nach dem Aufbringen. Der Sinterprozess wird üblicherweise in konventionellen Öfen durch den direkten Wärmeeintrag in die bedruckten Halbzeuge oder Bauteile vorgenommen.

### Stand der Technik

Bei bekannten Sinterverfahren wird das gesamte Material, d.h. sowohl das Substrat, als auch das in der Regel vergleichsweise geringe Volumen an Leitermaterial erwärmt. Bei der konventionellen Erwärmung von Materialien wird die Kombination von Leitermaterial und Substrat auf die notwendige Sintertemperatur gebracht. Die notwendige Sintertemperatur, beispielsweise für leitfähige Tinten, ist typischerweise 120°C.

Es gibt Substrate aus Kunststoffen, welche Wärmeformbeständigkeiten oberhalb 120° C aufweisen und deren Geometrie sich während des Sinterprozesses nicht signifikant ändert. Diese Substrate sind in der Regel teurer und/oder schwieriger zu verarbeiten als solche mit geringerer Wärmefombeständigkeit.

Die Veröffentlichung "Microwave Flash Sintering of Inkjet-Printed Silver Tracks on Polymer substrates" von Jolke Perelaer, Mark Klokkenburg, Chris E. Hendriks und Ulrich S. Schubert in Advanced Materials 2009, Bd. 21, S. 4830-4834 offenbart die Verwendung von Mikrowellen zur Wärmebehandlung von Leiterbahnen aus Silber. Die Druckschrift führt ausdrücklich aus, dass die Gründe für eine erfolgreiche Erwärmung von Metallpartikeln nicht bekannt sind. Verwendet wurde ein Biotage Initiator monomodales Mikrowellensystem, welches auch auf der Webseite www.biotage.com offenbart ist. Die verwendeten Proben haben Abmessungen von nur wenigen mm in rotierenden Probengefäßen und das Mikrowellensystem, welches für Aufschlüsse im Labor konzipiert ist, ist für das Sintern von Leitermaterial auf größeren Komponenten ohne zusätzliches Probengefäß vollständig ungeeignet. Mikrowellenaufschlüsse werden in der Chemie insbesondere deshalb verwendet, weil die Chemikalien an allen Stellen gleichzeitig erwärmt werden.

Aus der DE 10 2015 111 555 B3 ist ein Mikrowellen-Applikator bekannt, der zur Mikrowellenbehandlung größerer Komponenten vorgesehen ist. Mit der bekannten Anordnung soll das gesamte Material des Werkstücks behandelt werden.

US 2011 0283533 A1 offenbart das Aufbringen und Sintern von leitenden Tinten auf flexible, flache Materialien. Für diese Materialien wird keine hohe Formstabilität gefordert.

### Offenbarung der Erfindung

Es ist Aufgabe der Erfindung, die Nachteile des Standes der Technik zu überwinden und weitere Anwendungsgebiete zu finden. Erfindungsgemäß wird die Aufgabe dadurch gelöst, dass
(c) das Substrat aus einem unpolaren und/oder mikrowellen-transparenten, temperaturlabilen Material besteht, dessen Form, Zusammensetzung, Härte, mechanische Festigkeit, mechanische Steifigkeit oder anderer Zustand sich bei Erwärmung auf Temperaturen oberhalb von 120°C derart ändert, dass eine Messgröße oder ein Paramter sich außerhalb der Spezifikation des Bauteiles befindet und/oder aufgrund der Temperatur-bedingten Veränderung nicht wirtschaftlich verwertbar ist und, und
(d) das Substrat von einem Formteil mit dreidimensionalen Strukturen gebildet ist.

Zu den Behandlungsparametern gehören insbesondere die Bestrahlungsdauer, die Leistung der Mikrowellenstrahlung, die Wellenlänge der Mikrowellenstrahlung und der Abstand des Mikrowellengenerators zum Werkstück. Zu den Behandlungsparametern können aber auch andere Parameter, etwa die Verteilung der Bestrahlungsintensität oder der Zustand des Leitermaterials vor der eigentlichen Behandlung gehören.

Temperaturlabile Substrate sind Substrate mit einer Wärmeformbeständigkeit unterhalb der jeweiligen Sintertemperatur. Bei temperaturlabilen Substraten kann die Erwärmung auf eine höhere Sintertemperatur zu einer Änderung der Geometrie führen. Dies kann eine Deformation durch Aufschmelzen sein. Es kann bei solchen Temperaturen auch ein beginnendes Aufschmelzen des thermoplastischen Substratmaterials erfolgen. Auch andere für die wirtschaftliche Verwertung wichtige Eigenschaften, wie etwa die Farbe können sich verändern. Temperaturlabiles Material, dessen Form, Zusammensetzung, Härte, mechanische Festigkeit, mechanische Steifigkeit oder anderer Zustand sich bei Erwärmung auf Temperaturen oberhalb von 120°C messbar ändert, kann wirtschaftlich nicht mehr verwertet werden. Dabei wird unter dem Begriff "messbar" die Messung in einer für die Applikation üblichen Qualitätskontrolle verstanden. So werden in sicherheitsrelevanten Applikationen sehr genaue Messungen durchgeführt und es dürfen nur geringere Toleranzen über- oder unterschritten werden.

Besonders vorteilhaft ist es daher, dass nur das Leitermaterial gut erwärmt wird und das Substrat praktisch gar nicht erwärmt wird. Das ist besonders bei Substraten der Fall, die keine oder nur wenig Dipole enthalten, so dass die Mikrowellenstrahlung bei der ausgewählten Wellenlänge nicht oder nur wenig von dem Substratmaterial absorbiert wird.

Unter Leitermaterial wird hier insbesondere Material mit einer Leitfähigkeit zwischen 3·10⁶ S/m und 7·10⁷ S/m und Partikel aus solchem Material in einer Matrix verstanden. Beispiele für Leitermaterial sind Tinten in Form von Dispersionen mit Silber (Ag) und Carbon (C) - Teilchen, beispielsweise Ruß.

Die Erfindung sieht vor, dass das Substrat aus einem unpolaren und/oder mikrowellentransparenten, temperaturlabilen Material besteht, dessen Form, Zusammensetzung, Härte, mechanische Festigkeit, mechanische Steifigkeit oder anderer Zustand sich bei Erwärmung auf Temperaturen oberhalb von 120°C derart ändert, dass das Material für eine wirtschaftliche Verwertung ungeeignet ist. Dies ist insbesondere bei unpolaren und folglich mikrowellentransparenten Materialien der Fall. Die Energie der Mikrowellen wird überwiegend auf das Leitermaterial übertragen. Das Substratmaterial ist für die Mikrowellen transparent. Dadurch wird das Substratmaterial wenig oder gar nicht erwärmt und entsprechend geschont. Die Erfindung ermöglicht es, auch solche temperaturempfindlichen, kostengünstigeren Substrate zu verwenden, die bisher als Substrat zum Aufbringen von Leiterbahnen grundsätzlich nicht zugänglich waren.

Die Erfindung ist besonders wirtschaftlich, wenn vorgesehen ist, dass das Substrat Abmessungen wenigstens in einer Richtung oberhalb von 10 cm, vorzugsweise oberhalb von 50 cm und höchst vorzugsweise oberhalb von 80 cm aufweist. Es können also besonders große Substrate behandelt werden, die nicht in ein Mikrowellengerät mit rotierender Probe hineinpassen, das typischerweise in der Chemie verwendet wird. Vielmehr können große Mikrowellenanlagen verwendet werden, welche Kunststoffbauteile beispielsweise für die Fahrzeugindustrie oder in der Luftfahrt aufnehmen können. Eine solche Anlage ist beispielsweise in der DE 10 2015 111 555 B3 ausführlich beschrieben. Das Verfahren eignet sich erfindungsgemäß für Substrate, die von einem Formteil mit drei-Dimensionalen Strukturen gebildet sind.

Vorzugsweise ist vorgesehen, dass das Substrat zumindest teilweise aus einem Material besteht, das ausgewählt ist aus Polyethylen (PE), Polypropylen (PP), Polystyrol (PS), Polyamid (PA), Polycarbonat (PC), Polymethylmethacrylat (PMMA), ABS, PVC, PET, POM, PBT oder Mischungen oder Zusammensetzungen daraus. Diese Materialien sind vergleichsweise kostengünstig. Sie sind aber nicht temperaturstabil bei Temperaturen oberhalb von 120°C. Bei der Energieübertragung mittels Mikrowellen auf das Leitermaterial wird keine oder nur wenig Energie auf das Substrat übertragen, so dass auch kostengünstigere Materialien mit Leitermaterial beschichtet und gesintert werden können. Statt eines Polymers sind auch natürliche Materialien, beispielsweise Holz, Papier oder Pappe als Substrat geeignet.

Bei einer weiteren Ausgestaltung der Erfindung ist vorgesehen, dass das Leitermaterial in Form von Leiterbahnen aufgebracht wird. Diese können insbesondere als Stromleitungen, beispielsweise zu Heiz- oder Steuerzwecken, eingesetzt werden. Es ist aber auch möglich, das Leitermaterial flächig aufzubringen, etwa für die Verwirklichung von Reflektoren, Abschirmflächen, Dekorationen oder dergleichen.

Bei einer weiteren Ausgestaltung der Erfindung ist vorgesehen, dass die Leiterbahnen mittels Tintenstrahl-, Aerosol-, Sieb-, Tampondruck oder anderer Druckverfahren aufgebracht werden. Es ist auch möglich, die Leiterbahnen Sprühen oder Rakeln aufzubringen. Die leitenden Partikel befinden sich in einer Flüssigkeit, die nach dem Aufbringen mittels Sintern entfernt wird.

Insbesondere kann vorgesehen sein, dass das Leitermaterial Silber, Kupfer oder Carbonpartikel oder andere gut leitende Materialien oder Legierungen enthält.

Bei einigen Ausführungsbeispielen kann es gewünscht sein, dass eine aushärtende Deckschicht oder eine Deckschicht mit einem Reaktivklebstoff vor dem Sintern auf das Substrat mit dem Leitermaterial aufgebracht wird. Diese Deckschicht oder der Kleber können dann in nur einem Behandlungsschritt gleichzeitig mit dem Leitermaterial durch Behandlung mit Mikrowellen ausgehärtet werden.

Das erfindungsgemäße Verfahren kann mit einem Multimode-Mikrowellengenerator verwirklicht werden. Sie kann aber insbesondere auch dadurch verwirklicht werden, dass das Sintern mit Mikrowellenstrahlung mit einem Mikrowellengerät erfolgt, welches wenigstens einen Monomode-Mikrowellenapplikator aufweist. Bei einem Monomode-Mikrowellenapplikator - auch Monomode-Ofen genannt - bildet sich eine stehende Welle aus, deren Wellenlänge durch die Betriebsfrequenz festgelegt ist. Das Verfahren kann aber auch mit einer laufenden Welle betrieben werden. Die Antenne des Monomodes besteht gewöhnlich aus einem geschlitzten Vierkant, wobei die maximale Schlitzbreite durch die vorgegebene Wellenlänge bzw. Frequenz und die maximal mögliche Homogenität festgelegt ist. Innerhalb des üblicherweise sehr schmalen Schlitzes kann aber eine gute Homogenität erreicht werden. Der Applikator ist also besonders zum Sintern von Leitermaterialien auf flächigen Materialien geeignet.

Wird die Schlitzbreite größer gewählt, so tritt die Welle aus. Das ist unerwünscht. Dickere oder gekrümmte Materialien lassen sich mit einem solchen Monomodeapplikator nicht behandeln. Dann ist es sinnvoll, wenn das Sintern mit Mikrowellenstrahlung mit einem Mikrowellengerät erfolgt, welches zusätzlich wenigstens einen Multimode-Mikrowellenapplikator aufweist.

Bei Substraten, welche besonders lang sind (Endlosmaterial) oder bei Bahnen, beispielsweise von der Rolle, ist es besonders vorteilhaft, wenn das Substrat mit dem Leitermaterial durch das Mikrowellengerät befördert wird. Dadurch wird eine gleichmäßige Bestrahlung erreicht und punktuelle Beschädigungen des Substrats vermieden. Das Material kann aber auch oszilliert werden.

Vorzugsweise ist vorgesehen, dass die Leistung der Mikrowellenstrahlung entsprechend dem zu bestrahlenden Material eingestellt wird. Insbesondere kann eine hohe Leistung eingestellt werden, wenn der Sintervorgang in kurzer Zeit erfolgen soll. Eine niedrige Leistung kann eingestellt werden, wenn ausreichend Zeit zur Verfügung steht und/oder das Substrat bei einer höheren Leistung beeinträchtigt wird.

Besonders vorteilhaft ist es, wenn das Substrat mit dem Leitermaterial kontinuierlich und ungepulst mit Mikrowellenstrahlung bestrahlt wird. Anders als bei einem Mikrowellengerät, welches für die Erwärmung von Speisen in Haushalten vorgesehen ist, wird bei dieser Vorgehensweise die mittlere Leistung über die Verringerung oder Erhöhung der Amplitude und nicht zeitlich, d.h. längere oder kürzere Perioden ohne Bestrahlung, erreicht.

Bei einer weiteren Ausgestaltung der Erfindung ist vorgesehen, dass die Mikrowellen eine Wellenlänge zwischen 0,1 und 10 GHz, vorzugsweise zwischen 1 und 6 GHz und höchst vorzugsweise im Bereich zwischen 2,44 und 2,46 GHz und/oder 5,7 bis 5,9 GHz haben. Die beiden Bereiche sind in vielen Ländern zur Nutzung genehmigt und gewährleisten eine ausreichende Energieübertragung auf das Material. Es ist auch möglich, die Bestrahlung in beiden Wellenlängenbereichen gleichzeitig vorzunehmen.

Bei einer Ausgestaltung der Erfindung ist dem Sintern eine Vorbehandlung vorgeschaltet ist, bei welcher bereits ein Teil der Matrix aus dem Leitermaterial ausgetrieben wurde. Die Behandlung mit Mikrowellen dient dann beispielsweise der Erhöhung der Leitfähigkeit. Mit einer Vorbehandlung, etwa bei niedrigen Temperaturen, kann das ursprünglich flüssige Material aufgebracht und vorab transportfähig gemacht werden. Der eigentliche Sintervorgang erfolgt dann in einer Mikrowellenanlage mit Mikrowellen.

Bei der Durchführung des Verfahrens können zwei Behandlungsbereiche vorgesehen sein. Das Material wird bei jeder Behandlung durch beide Behandlungsbereiche befördert. Ferner wird sowohl ein Monomode- als auch ein Multimodeapplikator verwendet. Je nach Material können der Monomode- oder der Multimodeapplikator oder beide eingeschaltet werden. Es können also mit einer Anordnung alle Materialien behandelt werden unabhängig von den Abmessungen.

Aufgrund der erfindungsgemäßen Wahl von Substrat- und Leitermaterial ist vorgesehen, dass die Mikrowellen bevorzugt Energie im Leitermaterial dissipieren und nicht im Substrat. Das Leitermaterial kann beispielsweise eine leitfähige Tinte sein. Es kann vereinzelt dennoch vorteilhaft sein, wenn zusätzlich Energie aus einer Infrarot-Strahlungsquelle auf die Oberfläche des Materials übertragen wird.

Es kann auch vorgesehen sein, dass das Leitermaterial von einem elektrisch und/oder thermisch leitfähigen Klebstoff zur Herstellung einer mechanischen Verbindung gebildet ist.

Ausgestaltungen der Erfindung sind Gegenstand der Unteransprüche. Ein Ausführungsbeispiel ist nachstehend unter Bezugnahme auf die beigefügten Zeichnungen näher erläutert.

### Kurze Beschreibung der Zeichnungen

- Fig.1: ist eine Seitenansicht einer Anordnung zum Behandeln von Materialien mit Mikrowellen mit einem Multimodeapplikator, einem Monomodeapplikator und einer Infrarot-Strahlungsquelle.
- Fig.2: ist eine Draufsicht auf die Anordnung aus Figur 1.
- Fig.3: ist eine Vorderansicht der Anordnung aus Figur 1.
- Fig.4: ist ein schematischer Querschnitt durch ein Substrat mit aufgebrachtem Leitermaterial.
- Fig.5: ist eine schematische Draufsicht auf ein Substrat mit aufgebrachtem Leitermaterial.

### Beschreibung des Ausführungsbeispiels

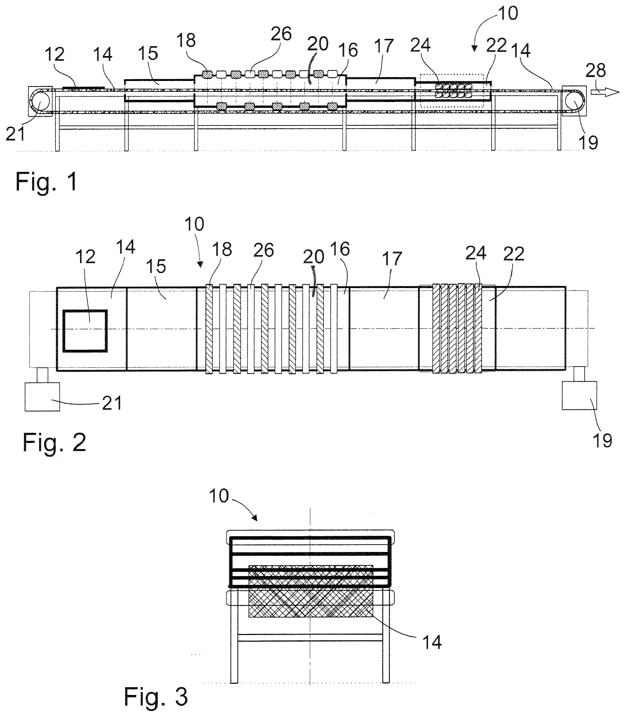

In den Figuren 1 bis 3 ist eine allgemein mit 10 bezeichnete Anordnung zum Behandeln von Materialien mit Mikrowellen 15 gezeigt. In der Anordnung können alle Arten von Materialien in Form von Stückgut oder Meterware behandelt werden, insbesondere Substrate 12 mit aufgebrachten Leiterbahnen 13. Den Leitermaterialien wird über Mikrowellen 15 Energie zugeführt, mit der das Leitermaterial 13 gesintert wird.

Das Leitermaterial 13 wird im vorliegenden Ausführungsbeispiel mittels Tintenstrahldrucken in Form von Leiterbahnen auf das Substrat 12 aufgebracht. Es versteht sich, dass aber auch andere Formen, etwa flächige Strukturen aus Leitermaterial aufgebracht werden können. Das Leitermaterial enthält im vorliegenden Ausführungsbeispiel leitende Partikel in einer flüssigen Matrix. Es ist aber auch möglich ein homogenes, flüssiges Leitermaterial zu verwenden.

Das Substrat 12 besteht aus einem Material, welches für Mikrowellen möglichst transparent ist. Entsprechend erfolgt praktisch keine oder relativ geringe Energieübertragung von den Mikrowellen 15 auf das Substrat. Beispiele für Substrate sind Polymere, wie etwa Polyethylen (PE), Polypropylen (PP), Polystyrol (PS), Polyamid (PA), Polycarbonat (PC), Polymethylmethacrylat (PMMA) oder Mischungen oder Zusammensetzungen daraus. Derartige Polymere sind temperaturlabil, d.h. ihre Form, Struktur oder Zusammensetzung ändert sich bei Erwärmung in einem Ofen auf Temperaturen oberhalb von 120°C. Es ist auch möglich, teurere, temperaturstabile Materialien als Substrat 12 zu verwenden, beispielsweise Polyimid (PI). Temperaturstabile Substrate können zwar auch in einem herkömmlichen Ofen eingesetzt werden. Bei dem vorliegenden Verfahren ist jedoch erheblich weniger Energie für den Sinterprozess erforderlich, da nur das Leitermaterial, nicht aber das Substrat erwärmt wird. Wichtig ist, dass ein ausreichender Unterschied in der Erwärmung Substrat- Leiterbahn vorhanden ist. je temperaturlabiler das Substrat, desto unpolarer und somit mikrowellentransparenter sollte es für das Mikrowellen-Sintern sein.

Die Figuren zeigen beispielhaft ein Substrat 12, welches auf einem Förderband 14 aus glasfaserverstärktem Teflon-Gitter befördert wird. Das Förderband ist durchlässig für Mikrowellen. Die Förderrichtung ist mit einem Pfeil 28 angezeigt. Das Förderband 14 tritt in eine von einem Gehäuse begrenzten Behandlungskammer 16 ein. Die Behandlungskammer 16 wird in einem ersten Behandlungsraum 20 von Mikrowellen der Frequenz 2,45 GHz eines Multimodeapplikators 18 durchstrahlt. In einem zweiten Behandlungsraum 22 wird die Behandlungskammer 16 von Mikrowellen 15 der Frequenz 2,45 GHz eines Monomodeapplikators 24 durchstrahlt. Ein dünnes Substrat 12, wie es in den Figuren dargestellt ist, kann mit dem Förderband durch beide Behandlungsräume 20 und 22 der Behandlungskammer 16 bewegt werden. Wenn beide Applikatoren eingeschaltet sind, wird das Substrat 12 mit dem Leitermaterial 13 zwei Mal einer Behandlung mit Mikrowellen ausgesetzt.

Die Mikrowellen 15 dringen in das Leitermaterial 13 und übertragen ihre Energie. Das Substrat 12 ist für die Mikrowellen transparent oder es wird nur wenig Energie absorbiert. Es erfolgt praktisch keine Energieübertragung. Dabei wird in den Leiterbahnen 13 Wärme erzeugt und das Material gesintert. Das Substrat 12 wird von den Mikrowellen nicht oder nur wenig erwärmt. Es findet praktisch keine Energieübertragung statt. Die Übertragung von Wärme aus den Leiterbahnen 13 auf das Substrat 12 ist vergleichsweise gering und verändert das Substrat 12 praktisch nicht, da das Volumen des Substrats 12 erheblich größer ist, als das Volumen der Leiterbahnen.

Jeder der Mikrowellenapplikatoren kann unabhängig voneinander eingeschaltet werden, so dass sich vielfältige Möglichkeiten der Behandlung für verschiedenartige Materialien in einer Anordnung ergeben.

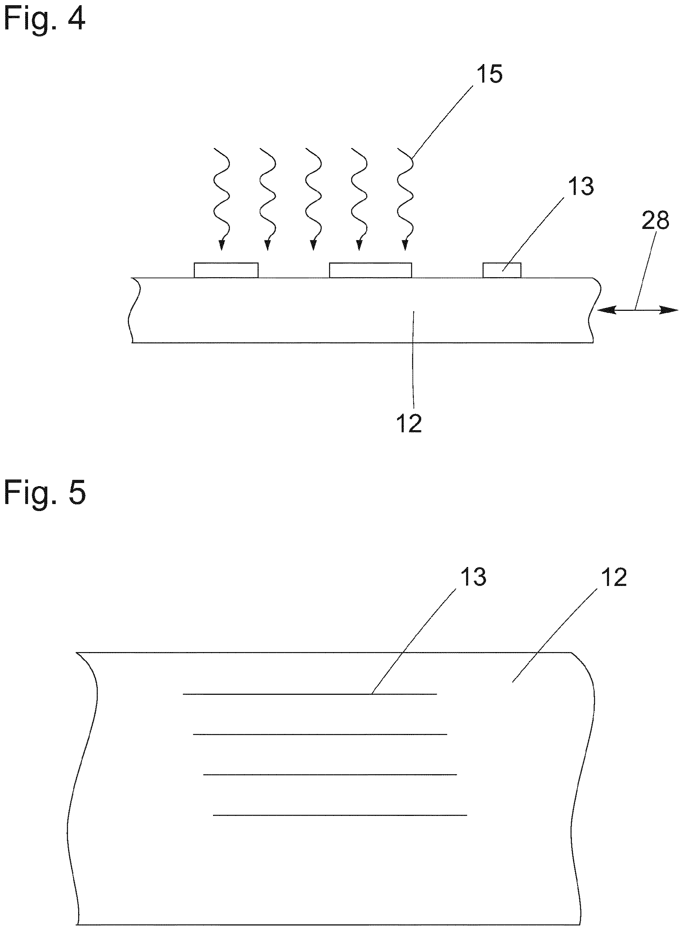

Figur 4 zeigt einen Ausschnitt aus Figur 1 mit dem Monomodeapplikator 24. Man erkennt, dass der Schlitz, durch den das Material 12 geführt ist, in vertikaler Richtung in diesen Ausführungsbeispiel sehr schmal ist. Die Anordnung sieht daher vor, dass das Magnetron des Monomodeapplikators einen einstellbaren Abstand 30 zum Förderband hat. Der Schlitz kann also für dickere oder gekrümmte Materialien, die vorzugsweise mit dem Multimodeapplikator 18 behandelt werden, vergrößert werden. Dann passen auch die diese Materialien mit größeren Abmessungen in vertikaler Richtung durch die Anordnung ohne größere Umbauten oder dergleichen vornehmen zu müssen.

Bei einem alternativen Ausführungsbeispiel (nicht dargestellt) ist vorgesehen, dass die Komponenten des Multimodeapplikators 18 vollständig aus dem Behandlungsbereich gefahren werden, wenn dicke oder gekrümmte Materialien mit größeren Abmessungen in vertikaler Richtung, durch den zweiten Behandlungsbereich 22 gefördert werden.

In den beschriebenen Ausführungsbeispielen wird das Substrat 12 mit dem Leitermaterial 13 in Richtung der Pfeile 28 durch die Anordnung bewegt. Es ist aber auch möglich, das Substrat 12 mit dem Leitermaterial einer oszillierenden Bewegung auszusetzen oder gar nicht zu bewegen. Durch die Bewegung wird eine besonders gleichmäßige Bestrahlung auch in Mikrowellenfeldern mit Intensitätsschwankungen erreicht.

Bei Bestrahlung von 2 dünnen Proben, mit Bahnen aus Silber-Tinte bedruckt wurden wurde die Leistung der Magnetrons sukzessive bis 1 kW (2,45 GHz) bzw. 750 W (5,8 GHz) erhöht. Die Temperaturen wurden mit einem Pyrometer gemessen. Es stellten sich Temperaturen an der Oberfläche des Sandwich-Teils von ca. 145°C ein. Mit einer Wärmekamera wurde eine Erwärmung der Bereiche in Nachbarschaft der Leiterbahnen nach der Mikrowellenbestrahlung gefunden. Dies zeigt, dass hier eine Wärmeübertragung von den heißen Leiterbahnen erfolgt ist, aber kein gleichmäßiger Wärmeeintrag durch Mikrowellenstrahlung. Statt Pyrometer und Wärmebildkamera kann die Temperaturverteilung auch mit faseroptischen Sensoren ermittelt werden.

Das Sintern (Tempern) des Leitermaterials per Mikrowelle führt zu einer weiteren Verringerung des Widerstandes. Die Widerstände der Leiterbahnen 13 wurden mit einem Standard-Multimeter in etwa über die Länge der Leiterbahnen gemessen. Die Messwerte wurden über 5 Leiterbahnen gemittelt.

Die erste Probe hatte vor der Bestrahlung einen Widerstand von 1,9 Ohm, nach der Bestrahlung einen Widerstand von 1,2 Ohm. Man erkennt, dass der Nach-Sinterprozess mit Mikrowellenstrahlung eine Verringerung des Widerstands, d.h. eine Erhöhung der Leitfähigkeit bewirkt. Bei der zweiten Probe wurde der Widerstand von 2,2 Ohm auf 1,2 Ohm gesenkt.

Im vorliegenden Ausführungsbeispiel wurden zwei vorbehandelte Proben verwendet. Daran kann man erkennen, dass nicht der komplette Sinterprozess mit Mikrowellenstrahlung erfolgen muss. Es ist auch möglich, das Leitermaterial bei geringeren Temperaturen im Ofen vorzubehandeln und anschließend mit Mikrowellen eine Erhöhung der Leitfähigkeit durch Sintern zu erreichen.

Die Parameter-Bereiche können wie folgt definiert werden. Wenn die Substrat-Materialien ein Tg/Obergrenze Thermische Formstabilität/Tm < 100...120°C aufweisen, kann das Verfahren vorteilhaft sein, dass klassische Sintern versagt auf jeden Fall.

Bei Temperaturen von 100...120°C werden Prozesszeiten von 20...40 min erreicht, je nach Probe bzw. Tinte. Die Leistung kann auch stufenweise erhöht und pro Leistung immer einige min gewartet werden, ob es blitzt und ob die Temperatur sich wie angestrebt verhält, d.h. nicht plötzlich nach oben wegläuft. Bei bekannten Systemen lässt sich die Zeit deutlich reduzieren, weil sofort mit einer zuvor als unkritisch ermittelten Leistung gearbeitet werden kann.

## Patentansprüche

1. Verfahren zum Aufbringen von Leitermaterial auf Substrate mit den Schritten:
(a) Aufbringen des Leitermaterials in einer flüssigen oder vorbehandelten Matrix auf ein Substrat; und
(b) Entfernen der Matrix und Sintern des Leitermaterials mittels Mikrowellenstrahlung, indem das aufgebrachte Leitermaterial mit der Matrix auf eine Temperatur oberhalb von 120°C gebracht wird, wobei die Materialeigenschaften des Leitermaterials und/oder des Substrats und/oder Behandlungsparameter derart ausgewählt sind, dass das Leitermaterial mehr erwärmt wird als das Substrat;
**dadurch gekennzeichnet, dass**
(c) das Substrat aus einem unpolaren und/oder mikrowellen-transparenten, temperaturlabilen Material besteht, dessen Form, Zusammensetzung, Härte, mechanische Festigkeit, mechanische Steifigkeit oder anderer Zustand sich bei Erwärmung auf Temperaturen oberhalb von 120°C derart ändert, dass eine Messgröße oder ein Paramter sich außerhalb der Spezifikation des Bauteiles befindet und/oder aufgrund der Temperatur-bedingten Veränderung nicht wirtschaftlich verwertbar ist, und
(d) das Substrat von einem Formteil mit dreidimensionalen Strukturen gebildet ist.

2. Verfahren nach Anspruch 1, **dadurch gekennzeichnet, dass** das Substrat Abmessungen wenigstens in einer Richtung oberhalb von 10 cm, vorzugsweise oberhalb von 50 cm und höchst vorzugsweise oberhalb von 80 cm aufweist.

3. Verfahren nach einem der vorgehenden Ansprüche, **dadurch gekennzeichnet, dass** das Substrat zumindest teilweise aus einem Material besteht, das ausgewählt ist aus Polyethylen (PE), Polypropylen (PP), Polystyrol (PS), Polyamid (PA), Polycarbonat (PC), Polymethylmethacrylat (PMMA), ABS, PVC, PET, POM, PBT oder Mischungen oder Zusammensetzungen daraus.

4. Verfahren nach einem der vorgehenden Ansprüche, **dadurch gekennzeichnet, dass** das Leitermaterial in Form von Leiterbahnen aufgebracht wird.

5. Verfahren nach Anspruch 4, **dadurch gekennzeichnet, dass** die Leiterbahnen mittels Tintenstrahl-, Aerosol-, Sieb-, Tampondruck oder anderer Druckverfahren aufgebracht werden.

6. Verfahren nach einem der vorgehenden Ansprüche, **dadurch gekennzeichnet, dass** das Leitermaterial Silber, Kupfer oder Carbonpartikel oder andere gut elektrisch leitende Materialien oder Legierungen enthält.

7. Verfahren nach einem der vorgehenden Ansprüche, **dadurch gekennzeichnet, dass** eine aushärtende Deckschicht oder eine Deckschicht mit einem Reaktivklebstoff vor dem Sintern auf das Substrat mit dem Leitermaterial aufgebracht wird.

8. Verfahren nach einem der vorgehenden Ansprüche, **dadurch gekennzeichnet, dass** das Sintern mit Mikrowellenstrahlung mit einem Mikrowellengerät erfolgt, welches wenigstens einen Monomode-Mikrowellenapplikator aufweist.

9. Verfahren nach Anspruch 8, **dadurch gekennzeichnet, dass** das Sintern mit Mikrowellenstrahlung mit einem Mikrowellengerät erfolgt, welches zusätzlich wenigstens einen Multimode-Mikrowellenapplikator aufweist.

10. Verfahren nach Anspruch 8 oder 9, **dadurch gekennzeichnet, dass** das Substrat mit dem Leitermaterial durch das Mikrowellengerät befördert wird.

11. Verfahren nach einem der vorgehenden Ansprüche, **dadurch gekennzeichnet, dass** die Leistung der Mikrowellenstrahlung entsprechend dem zu bestrahlenden Material eingestellt wird.

12. Verfahren nach einem der vorgehenden Ansprüche, **dadurch gekennzeichnet, dass** das Substrat mit dem Leitermaterial kontinuierlich und ungepulst mit Mikrowellenstrahlung bestrahlt wird.

13. Verfahren nach einem der vorgehenden Ansprüche, **dadurch gekennzeichnet, dass** die Mikrowellen einer Frequenz zwischen 0,1 und 10 GHz, vorzugsweise zwischen 1 und 6 GHz und höchst vorzugsweise im Bereich zwischen 2,44 und 2,46 GHz und/oder 5,7 bis 5,9 GHz haben.

14. Verfahren nach einem der vorgehenden Ansprüche, **dadurch gekennzeichnet, dass** dem Sintern eine Vorbehandlung vorgeschaltet ist, bei welcher bereits ein Teil der Matrix aus dem Leitermaterial ausgetrieben wurde.

15. Verfahren nach einem der vorgehenden Ansprüche, **dadurch gekennzeichnet, dass** das Leitermaterial von einem elektrisch und/oder thermisch leitfähigen Klebstoff zur Herstellung einer mechanischen Verbindung gebildet ist.
